# EUROPEAN PATENT APPLICATION

(11) **EP 3 804 992 A1**
(43) Date of publication of application: **14.04.2021**
(21) Application number: 18922445.4
(22) Date of filing: 11.06.2018
(51) Int. Cl.: B41F 15/24, H05K 3/34

(54) **CLAMP RAIL UNIT**

(71) Applicant: Fuji Corporation, Chiryu-shi, Aichi 472-8686 (JP)
(72) Inventor: FUKAKUSA, Shoji, Chiryu-Shi Aichi 472-8686 (JP)
(74) Representative: Grünecker Patent- und Rechtsanwälte PartG mbB
(86) International application number: PCT/JP2018/022190
(87) International publication number: WO 2019/239452

(57) **Abstract**

A clamp rail unit having a top clamping plate integrated therewith includes: a clamp rail having a side clamping surface that is brought into contact with a board in a width direction, and a storage section that is open on an upper surface; the top clamping plate that is stored in the storage section of the clamp rail; a parallel link mechanism in which the top clamping plate is used as an intermediate link and a drive link and a driven link having the same length are pivotally mounted; a drive mechanism that swings the drive link; and a support member that is fixed to the lower surface side of the clamp rail, in which the clamp rail and the support member are used as a base member, and a fixed link constituting the drive mechanism and the parallel link mechanism is mounted to the base member.

## Description

### Technical Field

The present invention relates to a clamp rail unit capable of switching between a side clamping, pressing a board from a width direction, and a top clamping, supporting an end portion in the width direction of the board from above, in addition to the width direction's pressing.

### Background Art

A clamp member that presses and holds a board in a width direction is used in a board holding device that configures a screen printing machine described in Patent Literature 1 below, for example. The Patent Literature 1 discloses a board holding device that enables not only side clamping of pressing and holding a board in a horizontal posture from the width direction but also top clamping of supporting an end portion of the board from above. In the top clamping, the end portion of the board lifted from below is brought into contact with a positioning plate. The positioning plate is assembled to a drive mechanism that enables movements in an up-down direction and a horizontal directions, and is configured to move between an outer retracted position corresponding to the side clamping and an upper clamping position corresponding to the top clamping, with respect to a clamp unit that clamps the board.

Further, a board holding device of Patent Literature 2 below also discloses a configuration in which two types of clamping are possible. The board holding device of Patent Literature 2 has a configuration in which a pair of clamp pieces is disposed at the same height and relatively moves so as to adjust the distance between them to hold a loaded board. Pressing plates for executing the top clamping are disposed in parallel at the pair of clamp pieces, and each of the pressing plates is configured such that the rotation of a rotary cylinder is transmitted thereto through a parallel link. Therefore, the pressing plate is made to move to a retracted position outside the clamp piece so as not to interfere with a mask or the like, at the time of the side clamping, and move to a pressing position where it rides on the clamp piece and presses the end portion in the width direction of the board from above, at the time of the top clamping.

### Patent Literature

Patent Literature 1: Japanese Laid-open Patent Publication No. 10-296948
Patent Literature 2: Japanese Laid-open Patent Publication No. 2001-38875

### Summary of the Invention

### Technical Problem

In the above conventional arts, each of the positioning plate and the pressing plate for performing the top clamping has a structure made so as to ride on the clamp piece from the outside. Therefore, the positioning plate of Patent Literature 1 is configured such that a first cylinder that enables the movement in the up-down direction and a second cylinder that enables the movement in the horizontal direction are integrated by a connection member, and the structure for enabling the top clamping is increased in size. Further, since the pressing plate of Patent Literature 2 is a large member bent into a substantially L shape, which greatly moves from the outside of the clamp piece to overlap the clamp piece, the structure for performing the top clamping is also increased in size. However, the structure of a screen printing machine or the like in which such a board holding device is incorporated is becoming more complicated year by year, while the demand for downsizing is increasing. Therefore, downsizing of the board holding device that enables the top clamping is desired.

Therefore, in order to solve such a problem, the present invention has an object to provide a clamp rail unit provided with a top clamping plate.

### Solution to Problem

According to an aspect of the present invention, there is provided a clamp rail unit including: a clamp rail having a side clamping surface that is brought into contact with a board in a width direction, and a storage section that is open on an upper surface thereof; a top clamping plate that is stored in the storage section of the clamp rail; a parallel link mechanism in which the top clamping plate is used as an intermediate link and a drive link and a driven link having the same length are pivotally mounted thereto; a drive mechanism that swings the drive link; and a support member that is fixed to a lower surface side of the clamp rail, wherein the clamp rail and the support member are used as a base member, and a fixed link constituting the drive mechanism and the parallel link mechanism is mounted to the base member.

### Advantageous Effect of the Invention

With the above configuration, it is possible to perform the side clamping of bringing the side clamping surface of the clamp rail into contact with the board from the width direction, and the top clamping that causes the top clamping plate to support the end portion in the width direction of the board from above while bringing the side clamping surface into contact with the board, and at the time of the side clamping, the top clamping plate is stored in the storage section of the clamp rail, and at the time of the top clamping, the top clamping plate moves through the drive mechanism or the parallel link mechanism formed integrally with the clamp rail.

### Brief Description of Drawings

Fig. 1 is a diagram showing an internal structure of a screen printing machine in a simplified manner.
Fig. 2 is a perspective view in a side clamping state where a board is held by a pair of clamp rail units.
Fig. 3 is a perspective view in a top clamping state where the board is held by the pair of clamp rail units.
Fig. 4 is a perspective view showing a top clamp device in the side clamping state.
Fig. 5 is a perspective view showing the top clamp device in the top clamping state.
Fig. 6 is a partial sectional view of the clamp rail unit showing a side surface of the top clamp device which is in the side clamping state.
Fig. 7 is a partial sectional view of the clamp rail unit showing the side surface of the top clamp device which is in the top clamping state.

### Description of Embodiments

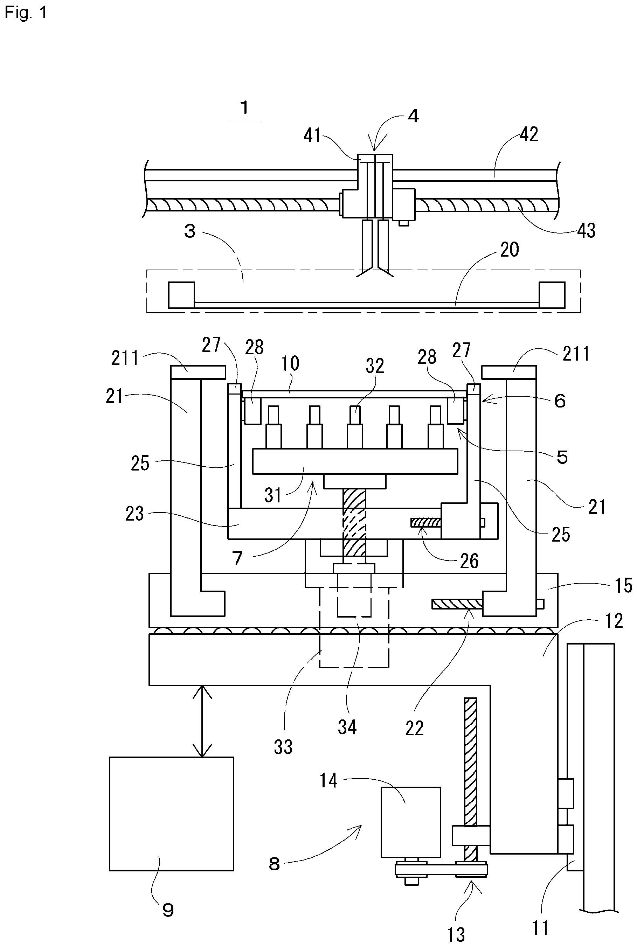

Next, an embodiment of a clamp rail unit according to the present invention will be described below with reference to the drawings. In a screen printing machine, a board mounting machine, or the like, predetermined work such as printing in which cream solder is applied to a positioned board or component mounting for mounting electronic components is performed. In a board holding device that holds a board in such work, a clamp rail unit is used as a component for pressing the board. In the present embodiment, the clamp rail unit incorporated in the board holding device will be described by taking a screen printing machine as an example. Fig. 1 is a diagram showing the internal structure of the screen printing machine in a simplified manner and is a diagram as viewed from a machine body width direction that is a board conveyance direction.

In screen printing machine 1, conveyance ports are formed on both side surfaces in the machine body width direction (a direction penetrating the drawing), and loading and unloading of board 10 is performed through the conveyance ports. Board 10 sent into the machine is positioned below mask 20, and is applied with cream solder passing through printing pattern holes of mask 20. In screen printing machine 1, mask holder 3 is provided on the upper side of the interior of the machine, and mask 20 having the printing pattern holes is held by mask holder 3. Squeegee device 4 is provided on the upper side of mask 20, and a pair of squeegees is mounted to traveling table 41 in a state of being movable up and down. Traveling table 41 is assembled to be slidable with respect to guide rod 42 and can be moved in a machine body front-rear direction (a left-right direction in the drawing) by a drive motor through a ball screw mechanism which includes screw shaft 43.

On the other hand, on the lower side of mask 20, board conveyance device 5 which conveys board 10, board holding device 6 which clamps board 10 from the width direction, backup device 7 which moves board 10 up and down to a clamping position, and the like are assembled to lifting and lowering device 8. In lifting and lowering device 8, lifting and lowering table 12 is slidably mounted to guide rail 11 which is in a vertical direction. Lifting and lowering table 12 is connected to lifting and lowering motor 14 through ball screw mechanism 13 and can move in an up-down direction. Support table 15 is mounted on lifting and lowering table 12, and the position of support table 15 can be adjusted in an X direction, a Y direction, and a θ direction on an X-Y plane by a correction device.

A pair of mask supports 21 is provided at support table 15 in the machine body front-rear direction, and support plate 211 is fixed to an upper end portion of mask support 21. Ball screw mechanism 22 is provided at mask support 21 on the right side in the drawing, and the distance between ball screw mechanism 22 and mask support 21 which is located on the left side in the drawing can be adjusted by a drive motor. Then, board holding device 6 which holds board 10 is provided between the pair of mask supports 21. Board holding device 6 has a pair of side frames 25 in the machine body front-rear direction orthogonal to a conveyance direction of board 10, and side frames 25 are assembled onto support table 23. Ball screw mechanism 26 is configured on side frame 25 on the right side in the drawing, and the distance between ball screw mechanism 26 and side frame 25 which is located on the left side in the drawing can be adjusted by a drive motor.

Clamp rail unit 27 is mounted to an upper end portion of each of the pair of side frames 25, and the distance between clamp rail units 27 becomes closer, whereby holding of pressing board 10 from the width direction becomes possible. Then, board conveyance device 5 which includes conveyor belt 28 is assembled inside side frame 25, and backup device 7 which supports board 10 from below is further provided between the pair of side frames 25.

Backup device 7 is configured such that backup table 31 provided with multiple backup pins 32 is supported through a ball screw mechanism and is lifted and lowered by backup motor 34. Further, support table 23 of board holding device 6 is supported through a ball screw mechanism and is configured to be lifted and lowered by lifting and lowering motor 33. Then, control device 9 is mounted to screen printing machine 1, a printing control program for executing the printing on board 10 is stored therein, and predetermined drive control for each device is performed.

Next, in the printing on board 10 in screen printing machine 1, board 10 is conveyed to board holding device 6 by board conveyance device 5, and backup table 31 of backup device 7 is raised, so that board 10 is lifted from conveyor belt 28 by backup pins 32. Then, board 10 is held by the pair of clamp rail units 27 of board holding device 6. Board holding device 6 is raised by the driving of lifting and lowering motor 33 while holding board 10, and is positioned with respect to mask support plate 211. That is, the upper surface of each of clamp rail unit 27 and board 10 is aligned with the upper surface of mask support plate 211.

Thereafter, lifting and lowering table 12 is raised by the driving of lifting and lowering motor 14, and mask support plate 211, clamp rail unit 27, and board 10 are positioned at a printing position which is in contact with the lower surface of mask 20. On the upper surface side of mask 20, the cream solder is rolled by squeegee device 4, and the cream solder is applied to board 10 through the printing pattern holes of mask 20. Then, by plate releasing of lowering board 10 at a predetermined speed by the driving of lifting and lowering motor 33, printing according to a printing pattern is performed on board 10.

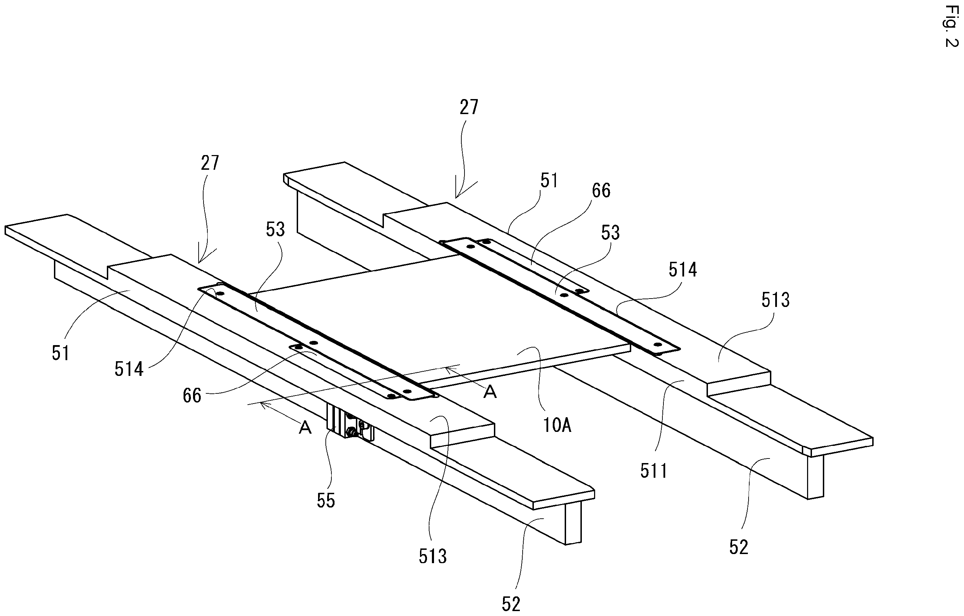

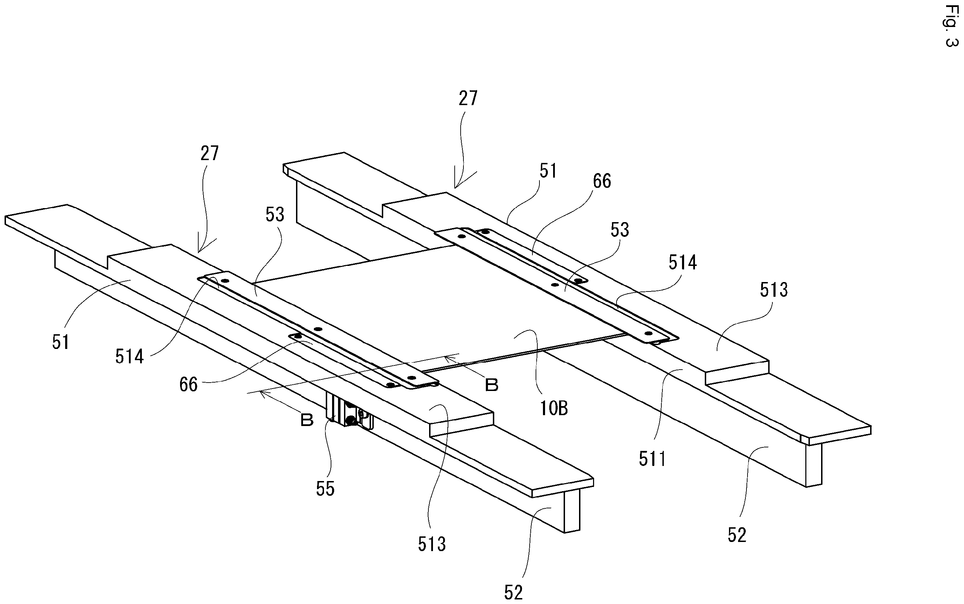

Screen printing machine 1 has been briefly described above; however, next, clamp rail unit 27 configuring board holding device 6 will be described. Clamp rail unit 27 enables not only the side clamping of pressing board 10 from a lateral direction but also the top clamping of supporting the end portion of the board from above so that even thin board 10, being likely to warp, can be stably held. Here, Figs. 2 and 3 are perspective views in a state where board 10 (10A, 10B) is held by the pair of clamp rail units 27, and in particular, Fig. 2 shows the side clamping state, and Fig. 3 shows the top clamping state.

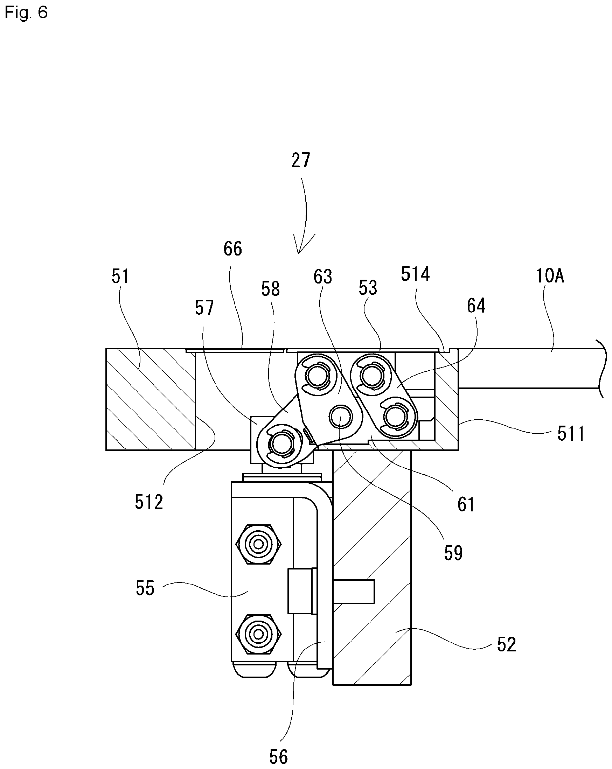

Clamp rail unit 27 has clamp rail 51 which is a long strip-shaped plate material, and support member 52 which is also a long strip-shaped plate material is fixed in a state of abutting to clamp rail 51 in an orthogonal direction from below. Clamp rail 51 is formed such that side clamping surface 511 to which board 10 abuts is a vertical surface. Further, clamp rail 51 is formed with storage section 512 that is open on the upper surface 513 side (refer to Fig. 6), and strip-shaped top clamping plate 53 is provided so as to close the opening portion of storage section 512.

Incidentally, in the case of the printing by the side clamping shown in Fig. 2, upper surface 513 of clamp rail 51 comes into contact with the lower surface of mask 20. At that time, since top clamping plate 53 in a state of being stored in storage section 512 becomes a part of upper surface 513, the upper surface of top clamping plate 53 needs to be at the same height as or a height equal to or lower than upper surface 513. In this embodiment, step 514 having a depth corresponding to the thickness of top clamping plate 53 is formed at a peripheral edge of the opening portion of storage section 512, and a configuration is made such that top clamping plate 53 stored with the end portion thereof abutting to step 514 has a surface having the same height as upper surface 513.

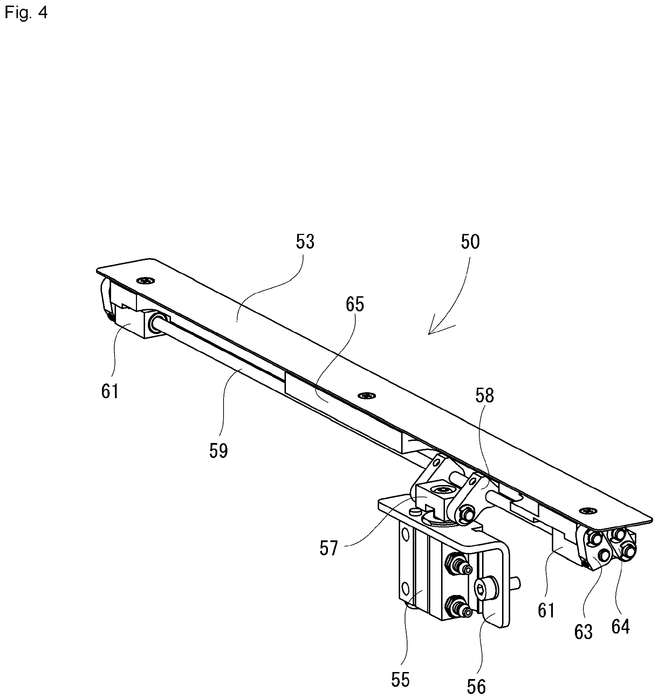

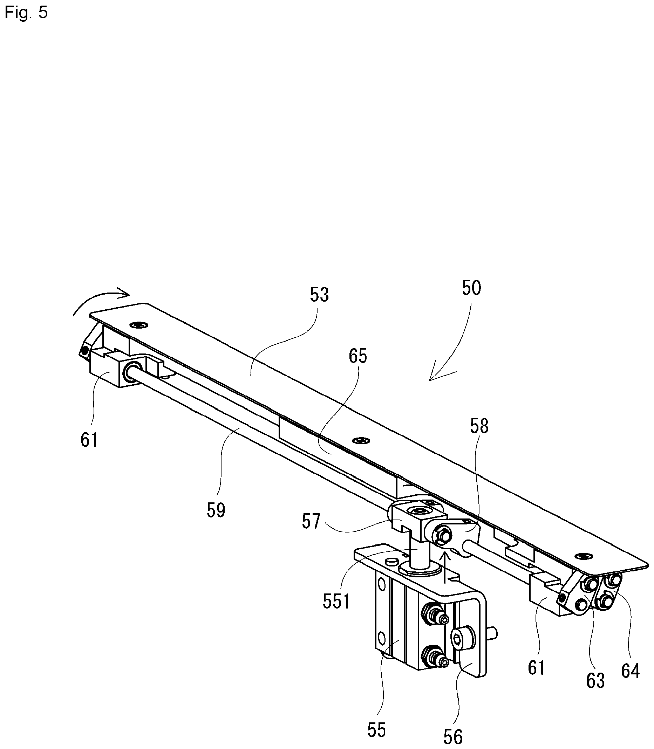

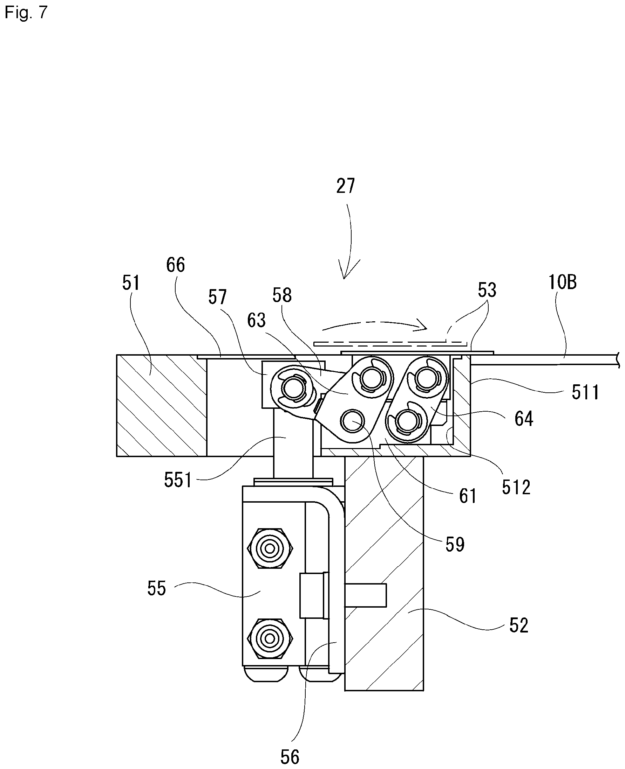

On the other hand, in a case where the end portion of the board has been warped, as shown in Fig. 3, the top clamping is performed in which the end portions in the width direction of board 10B are pressed from the width direction by the pair of side clamping surfaces 511 while being supported from above by top clamping plates 53. Therefore, clamp rail unit 27 is provided with a top clamp device for switching top clamping plate 53 to either the side clamping or the top clamping. Figs. 4 and 5 are perspective views showing the top clamp device, and Figs. 6 and 7 are partial sectional views of the clamp rail unit showing the side surface of the top clamp device. Then, Figs. 4 and 6 show the state at the time of the side clamping shown in Fig. 2, and Figs. 5 and 7 show the state at the time of the top clamping shown in Fig. 3. Fig. 6 shows a portion of a cross section taken along line A-A and viewed in an arrow direction in Fig. 2, and Fig. 7 shows a portion of a cross section taken along line B-B and viewed in an arrow direction in Fig. 3.

In top clamp device 50, air cylinder 55 is used as a drive source for operating top clamping plate 53. Air cylinder 55 is fixed to and integrated with bracket 56, and is mounted by screwing bracket 56 to support member 52. In air cylinder 55, piston rod 551 protrudes from bracket 56, and block 57 is fixed to the tip portion of piston rod 551. A first end portion of link 58 is pivotally mounted to each of both side portions of block 57 and rotary shaft 59 is fixed to a second end portion of link 58, whereby a crank mechanism that converts the extension and contraction operation of air cylinder 55 into the rotational movement of rotary shaft 59 is configured.

Rotary shaft 59 is parallel to the longitudinal direction of top clamping plate 53, and both end portions thereof are rotatably supported by fixed blocks 61. Two fixed blocks 61 are disposed at the end portions in the longitudinal direction of top clamping plate 53 and are fixed to support member 52. Rotary shaft 59 penetrates fixed blocks 61, and one end portion of drive link 63 is fixed to an end portion protruding to the outside. Therefore, a configuration is made in which the extension and contraction operation of air cylinder 55 causes the rotation of rotary shaft 59 along with the swing of link 58 and drive link 63 swings due to the rotation of rotary shaft 59.

Drive link 63 configures, along with driven link 64 having the same length, a parallel link mechanism in which fixed block 61 serves as a fixed link and top clamping plate 53 serves as an intermediate link. One end portion of driven link 64 is pivotally mounted to be rotatable with respect to fixed block 61, and thus swing with a rotary shaft thereof as a fulcrum becomes possible. Further, reinforcing block 65 is integrally formed by being attached to the back surface of top clamping plate 53, and the swinging end portion side of each of drive link 63 and driven link 64 is pivotally mounted to be rotatable with respect to reinforcing block 65.

The interval between the rotary shafts of drive link 63 and driven link 64 on the reinforcing block 65 side is equal to the interval between both the rotary shafts on the fixed block 61 side, and thus the parallel link mechanism is configured as described above. Then, the parallel link mechanisms are symmetrically configured at both end portions in the longitudinal direction of top clamping plate 53. Therefore, rotary shaft 59 is rotated by the extension and contraction operation of air cylinder 55, whereby the switching operation of top clamping plate 53 is performed by the parallel link mechanisms at both end portions in the longitudinal direction.

Clamp rail unit 27 is made such that clamp rail 51 and support member 52 integrated with each other serve as a base member and top clamp device 50 is directly assembled to the base member as one device. The assembly of top clamp device 50 is inserted into storage section 512 from the upper surface 513 side of clamp rail 51. At that time, storage section 512 is formed such that an entry portion for air cylinder 55 is expanded so as not to interfere with air cylinder 55, and is made such that lid member 66 having a height which is aligned with that of upper surface 513, similarly to the top clamping plate 53, can be mounted and dismounted.

In this manner, clamp rail unit 27 of this embodiment is configured such that top clamp device 50 is integrated with clamp rail 51, and in screen printing machine 1 shown in Fig. 1, clamp rail unit 27 is assembled to each of the pair of side frames 25 configuring board holding device 6. Then, as described above, in a case of performing printing on board 10, board 10 is pressed and held from the width direction by the pair of clamp rail units 27.

At that time, in the side clamping shown in Fig. 2, as shown in Figs. 4 and 6, air cylinder 55 is in a contracted state, so that drive link 63 and driven link 64 are tilted to the side opposite to side clamping surface 511, and top clamping plate 53 is stored in storage section 512 of clamp rail 51. Therefore, in a case where board 10A is held by the side clamping as shown in Fig. 2, the upper surfaces of clamp rail 51, top clamping plate 53, and board 10A are aligned with each other, and in that state, the upper surfaces are positioned at the printing position which is in contact with the lower surface of mask 20.

On the other hand, as shown in Fig. 3, in the top clamping with respect to thin board 10B, the state of clamp rail unit 27 is switched by air cylinder 55, as shown in Figs. 5 and 7. That is, piston rod 551 is pushed up by the extension operation of air cylinder 55, so that rotation is given to rotary shaft 59 through link 58 pivotally mounted to block 57. Then, drive link 63 that has received the rotation of rotary shaft 59 swings by a predetermined angle according to the stroke of piston rod 551.

At this time, top clamping plate 53 that functions as an intermediate link moves while maintaining a horizontal state, as shown by a dashed-dotted line in Fig. 7, by synchronous swing of drive link 63 and driven link 64 by the same angle. Since drive link 63 and driven link 64 swing to the opposite side clamping surface 511 side beyond the position in which drive link 63 and driven link 64 are in the vertical posture, top clamping plate 53 moves while slightly moving up and down. Therefore, top clamping plate 53 comes out of storage section 512 and is positioned so as to ride on the upper end portion of side clamping surface 511. At this time, top clamping plate 53 partially protrudes from side clamping surface 511.

Therefore, even if board 10B conveyed to screen printing machine 1 is warped, the end portion in the width direction, which is raised due to the warp, of board 10B lifted by backup pins 32 is brought into contact with top clamping plate 53 to be relatively pressed. Therefore, at the clamping position, the warp of board 10B is corrected, and board 10B in a flat state is held by being brought into contact with side clamping surfaces 511 from both sides in the width direction. On the other hand, in a case where clamp rail unit 27 is returned from the top clamping to the side clamping, piston rod 551 is lowered by the contraction operation of air cylinder 55, and top clamping plate 53 moves through the parallel link mechanism to be stored in storage section 512.

Clamp rail unit 27 of this embodiment has, as a whole, a compact configuration in which top clamping plate 53 is stored in storage section 512 on the upper surface side of clamp rail 51 and air cylinder 55, the parallel link mechanism, and the like are assembled to the back surface side. Therefore, a large space is not required for assembling clamp rail unit 27, which contributes to downsizing of board holding device 6 capable of switching the clamping state. Further, since the operating range of top clamping plate 53 of clamp rail unit 27 at the time of the switching of the clamping state is narrow, the configuration around board holding device 6, such as mask support 21, can also be made compact. Further, since each member of clamp rail unit 27 is configured integrally with clamp rail 51, the assembling work is also easy, similarly to the conventional art of only clamp rail 51.

An embodiment of the present invention has been described above; however, the present invention is not limited to the embodiment, and various modifications can be made within a scope which does not depart from the gist of the present invention. For example, in the above embodiment, a drive mechanism that converts the rotational movement of air cylinder 55 into the rotational movement of rotary shaft 59 by the crank mechanism is provided; however, a configuration may be adopted in which the rotation output of a rotary actuator is transmitted to rotary shaft 59 through a gear.

### Reference Signs List

1: screen printing machine
4: squeegee device
5: board conveyance device
6: board holding device
7: backup device
8: lifting and lowering device
10: board
25: side frame
27: clamp rail unit
50: top clamp device
51: clamp rail
52: support member
53: top clamping plate
55: air cylinder
56: bracket
58: link
59: rotary shaft
61: fixed block
63: drive link
64: driven link
65: reinforcing block
511: side clamping surface
512: storage section
513: upper surface

## Claims

1. A clamp rail unit comprising:
a clamp rail having a side clamping surface that is brought into contact with a board in a width direction, and a storage section that is open on an upper surface thereof;
a top clamping plate that is stored in the storage section of the clamp rail;
a parallel link mechanism in which the top clamping plate is used as an intermediate link and a drive link and a driven link having the same length are pivotally mounted thereto;
a drive mechanism that swings the drive link; and
a support member that is fixed to a lower surface side of the clamp rail,
wherein the clamp rail and the support member are used as a base member, and
a fixed link constituting the drive mechanism and the parallel link mechanism is mounted to the base member.

2. The clamp rail unit according to claim 1, wherein the parallel link mechanisms are provided at opposite end portions in a longitudinal direction of the top clamping plate, and a shaft portion of the drive link with respect to each of the fixed links at the opposite end portions is a common rotary shaft, and
in the drive mechanism, a piston rod of a cylinder is connected to the rotary shaft through a crank mechanism.

3. The clamp rail unit according to claim 1 or 2, wherein the top clamping plate, the parallel link mechanism, and the drive mechanism are assembled to the base member as a single top clamp device.
